# EUROPEAN PATENT APPLICATION

(11) **EP 4 462 959 A1**
(43) Date of publication of application: **13.11.2024**
(21) Application number: 23172875.9
(22) Date of filing: 11.05.2023
(51) Int. Cl.: H05K 1/11, G01R 1/20, H01C 1/14, H05K 3/34, H05K 1/02

(54) **ELECTRICAL ASSEMBLY, ELECTRICAL MEASUREMENT DEVICE AND MANUFACTURING METHOD**

(71) Applicant: TE Connectivity Solutions GmbH, 8200 Schaffhausen (CH)
(72) Inventor: SCHERNER, Simon, 8200 Schaffhausen (CH); ZAWADZKY, Peter, 8200 Schaffhausen (CH); GLASER, Karlheinz, 8200 Schaffhausen (CH); EBERLE, Marcus, 8200 Schaffhausen (CH); KARABIYIK, Hamdi, 8200 Schaffhausen (CH)
(74) Representative: Grünecker Patent- und Rechtsanwälte PartG mbB

(57) **Abstract**

The present invention relates to an electrical assembly (2) for an electrical measurement device (1), the electrical assembly (2) comprising a solid electrical conductor (22) and a printed circuit board (20) with at least one through-hole (26) and at least one electrically conductive trace (44) extending at least sectionally around the at least one through-hole (26), wherein on the solid electrical conductor (22) at least one tenon (62) and at least one elevation (64) extending around the at least one tenon (62) are monolithically formed from the material of the solid electrical conductor (22), wherein the at least one tenon (62) extends into the at least one through-hole (26), and wherein the at least one elevation (64) is in electrical contact with the at least one electrically conductive trace (44). The at least one through-hole (26) functions as a mortise for the at least one tenon (62), while the at least one electrically conductive trace (44) and the at least one elevation (64) create an electrical connection, which is independent from the mechanical connection established between the at least one tenon (62) and the at least one through-hole (26). Further, the present invention relates to an electrical measurement device (1) with such an electrical assembly (2) and a method for manufacturing such an electrical assembly (2).

## Description

### Technical Field to which the Invention relates and Background Art

The present invention relates to an electrical assembly for an electrical device, such as an electrical measurement device, control system unit or the like. Further, the present invention relates to an electrical measurement device comprising such an electrical assembly and a method for manufacturing such an electrical assembly.

For many applications in the field of electrical engineering, printed circuit boards (PCBs) of electrical devices need to be attached to a solid electrical conductor, such as a busbar, a shunt or any other type of conductor massively made of electrically conductive material. Conventionally, this kind of attachment is established by arranging a separate connection element between the printed circuit board and solid electrical conductor. The connection element then serves the double purpose of forming mechanical and electrical connections. As a consequence, the specific type and actual finishing quality of the mechanical connection utilized also impacts the quality of the electrical connection.

For the sake of consistent quality and reproducibility, it is desirable to minimize the above-mentioned impact and to improve the attachment of printed circuit boards to solid electrical conductors.

### Object to be achieved

The object of the present invention is to provide means for improving, in general, the attachment of printed circuit boards to solid electrical conductors, and in particular, for reducing the influence-ability of the electrical connection by the mechanical connection from such an attachment.

### Disclosure of Invention

The object is achieved by an electrical assembly of the above-mentioned kind, the electrical assembly comprising a solid electrical conductor and a printed circuit board with at least one through-hole and at least one electrically conductive trace extending at least sectionally around the at least one through-hole, wherein on the solid electrical conductor at least one tenon and at least one elevation extending around the at least one tenon are monolithically formed from the material of the solid electrical conductor, wherein the at least one tenon extends into the at least one through-hole, and wherein the at least one elevation is in electrical contact with the at least one electrically conductive trace.

The technical effects and advantages achieved by the above solution are as follows:
The at least one through-hole functions as a mortise and creates a joint with the at least one tenon, effecting a mechanical connection between the printed circuit board and the solid electrical conductor (henceforth: the mechanical connection). As clarified in the below description, the mechanical connection does not necessarily have to be established in a purely mechanical way. It only needs to have the capability to withstand mechanical force, which is expected to occur on the electrical assembly.

Due to the presence of the at least one electrically conductive trace and the at least one elevation, which are in mutual electrical contact, a contact surface between the printed circuit board and the solid electrical conductor is provided. Said contact surface establishes the electrical connection between the printed circuit board and the solid electrical conductor (henceforth: the electrical connection). This electrical connection is independent from the mechanical connection established between the at least one tenon and the at least one through-hole. In other words, having the electrical connection at a location that is separate from the mechanical connection results in less to no dependency between both connections.

Moreover, the at least one tenon and the at least one elevation being monolithically formed from the material of the solid electrical conductor eliminates the necessity for any separate fixation element. This results in less scrap being produced and less parts being required for the attachment of the printed circuit board to the solid electrical conductor. Less parts also means that less boundary areas between parts are present in the attachment, leading to a lower electrical transfer resistance. Hence, the electrical assembly is not only improved from an economic viewpoint, but it also exhibits better performance during operation compared to a conventional electrical assembly with a separate connection element.

If the electrical assembly is utilized for measurement applications, specifically electrical measurement applications, the at least one tenon and the at least one elevation being monolithically, and thus integrally formed from the material of the solid electrical conductor results in another advantage. Namely, less interconnections along the measurement path are present, which reduces therefore the Failures In Time (FIT Rate) effectively.

The above solution may be further improved by adding one or more of the following optional features. Each of the following optional features is advantageous on its own and may be combined independently with any other optional feature.

According to a first possible embodiment, the at least one tenon may be engaged in a soldered, welded, glued, riveted, force-fit and/or press-fit connection with the printed circuit board at the at least one through-hole. Since, as described above, the electrical connection between the printed circuit board and the solid electrical conductor is virtually independent of its mechanical connection, all of these connection types can be utilized for establishing the mechanical connection without the risk of affecting the electrical connection. This creates an adaptability to application requirements across a broad field.

Advantageously, conventionally available solid conductors may serve as raw material. For example, the solid electrical conductor may be made of copper, copper alloy, in particular copper wrought alloy, aluminum, aluminum alloy, stainless steel and/or any other metallic or metallized material with a ductility suitable for coining, stamping, pressing, punching, embossing and/or other similar processes that can be used for monolithically forming the at least one tenon and the at least one elevation from the material of the solid electrical conductor.

Optionally, the solid electrical conductor may comprise a coating, in particular a plasma coating, a plating, in particular a chemical plating or electro-plating, a brazing, a cladding or any other type of metal application to its surface. The applied metal may be a rare and/or precious and/or typical conductive metal (e.g., silver) or a rare and/or precious and/or typical conductive metal alloy for reduced contact resistance. The metal may be applied entirely or only partly on the solid electrical conductor. For example, a Sn metallization via plasma may be applied to the outer surface of the at least one tenon and/or elevation.

Further, the solid electrical conductor may be substantially flat or have at least one flat side. On said flat side of the solid electrical conductor, the at least one tenon and the at least one elevation may be monolithically formed from the material of the solid electrical conductor. Said flat side may be facing towards a bottom side of the printed circuit board and may be referred to as a top side of the solid electrical conductor. In other words, the at least one tenon and the at least one elevation may be located on the top side of the solid electrical conductor.

Herein, the at least one tenon may be a pillar-shaped, pin-shaped, prism-shaped, pole-shaped and/or post-shaped finger or protrusion. As such, the at least one tenon may protrude from the top side of the solid electrical conductor, in order to extend into the at least one through-hole. A tip of the at least one tenon may be flush with a top side of the printed circuit board or may even project from the top side of the printed circuit board. Thereby, the tip of the at least one tenon may be center-punched in order to arrive at the above-mentioned riveted connection. Upsetting or swaging may also be utilized to deform the tip of the at least one tenon to achieve the riveted connection. Alternatively, the tip of the at least one tenon may be located within the at least one through-hole, without sticking out of the printed circuit board.

In order to increase the contact pressure, the at least one elevation may extend discontinuously around the at least one tenon. For example, multiple knobs with a dome shape, spike shape, pyramid shape, cylinder shape, star shape or any other convexly protruding shape may be distributed around the at least one tenon, each knob defining a discrete contact point for the at least one electrically conductive trace. The knobs are preferably distributed in a circular arrangement and evenly or unevenly spaced apart from each other in a circumferential direction with respect to the at least one tenon. Moreover, the contact points may be mutually coplanar. This improves positional stability of the printed circuit board. Accordingly, the at least one electrically conductive trace may extend discontinuously around the at least one through-hole, in particular around an opening of the at least one through-hole on the above-mentioned bottom side of the printed circuit board.

Alternatively, if the contact surface needs to be increased, the at least one elevation may extend continuously around the at least one tenon. For example, the at least one elevation may be a ring-shaped bulge on the top side of the solid electrical conductor encircling the at least one tenon. Accordingly, the at least one electrically conductive trace may extend continuously around the at least one through-hole, in particular around an opening of the at least one through-hole on the above-mentioned bottom side of the printed circuit board.

A further increase of contact surface may be achieved, if the at least one through-hole comprises an electrically conductive internal surface that is in electrical contact with the at least one tenon. In particular, the at least one though-hole may be a via (vertical interconnect access). The electrically conductive internal surface may be achieved through a metallic plating, metallic coating and/or metallic insert sleeve located within the at least one through-hole. Preferably, the electrically conductive internal surface and the at least one conductive trace are electrically interconnected.

The printed circuit board may comprise a substrate made of glass-reinforced epoxy laminate material, in particular of the category FR-4 according to NEMA LI 1-1998 standard.

Optionally, a groove is formed on the solid electrical conductor between the at least one tenon and the at least one elevation. Said groove may be circular and/or annular and may extend around the at least one tenon in a circumferential direction with respect to the at least one tenon. In a radial direction with respect to the at least one tenon, the groove may separate the at least one tenon and the at least one elevation from each other. Thereby, the groove serves as a relief groove for clearance, allowing the printed circuit board to seat completely against the shoulder formed by the at least one elevation.

According to an embodiment especially suited for use in combination with the above-mentioned soldered connection, the at least one through-hole may comprise a stepped portion separating a wider section of the at least one through-hole from a narrower section of the at least one through-hole. Preferably, the wider section of the at least one through-hole is obtained as a counterbore hole or countersink hole. Herein, the at least one electrically conductive trace may border or at least be closer to the narrower section than to the wider section. Within this constellation, the wider section can be solder-filled for fixation purposes and the narrower section can be solder-filled for contacting purposes.

Optionally, at least one slit or notch may extend through the at least one elevation along the radial direction with respect to the at least one tenon. Preferably, multiple slits may be distributed in regular or irregular distances around the at least one elevation along the circumferential direction with respect to the at least one tenon. The slits may separate the at least one elevation into multiple ring segments, resulting in the discontinuously extending elevation already mentioned above.

A further function is fulfilled by the slit or slits in the context of the above-mentioned soldered connection. Namely, the slit or slits help with the de-aerating or venting of the through-hole during soldering. That is, a solid electrical conductor with a continuously extending elevation shuts the at least one through-hole and virtually turns it into a blind hole with a dead end, once the electrically conductive trace is in tight electrical contact with the elevation. Without any means of escape, an air/gas pocket can accumulate in the through-hole, preventing solder from sufficiently filling the through-hole. The slit or slits provide the necessary vent for the trapped air/gas.

According to another embodiment, the solid electrical conductor may comprise at least one indent or indentation on a back side of the solid electrical conductor facing away from the printed circuit board. Preferably, the at least one indent is located opposite of the at least one tenon as well as the at least one elevation with respect to the solid electrical conductor. The at least one indent creates a blind hole in the solid electrical conductor. This is a result of material displacement during the monolithic formation of the at least one tenon and the at least one elevation from the material of the solid electrical conductor.

Depending on the application requirements and the mechanical connection method of choice, the at least one tenon may have a circular or non-circular cross section. For example, the at least one tenon may have a circular, square, rectangular, triangular, polygonal, oval or elliptical cross section. In particular, an outer contour of the at least one tenon may be cylindrical, cubical, cuboidal, ellipsoidal, or cylindroidal. Accordingly, the at least one through-hole may have a circular or non-circular cross section, in particular for an inner contour.

Optionally, the at least one tenon may have slightly slanted outer surfaces like a truncated cone or pyramid to facilitate exit from a coining tool. The slant angle may range from 0,1° to 1°.

According to another embodiment, two or more tenons may be formed on the solid electrical conductor, wherein each tenon is surrounded by one elevation formed on the solid electrical conductor. Accordingly, the printed circuit board may comprise two or more through-holes surrounded by electrically conductive traces at respective locations corresponding with the locations of the tenons and elevations. Preferably, the two or more tenons are mutually parallel. The two or more through-holes, likewise, may extend parallel to each other. The elevations may be mutually coplanar, just like the electrically conductive traces are mutually coplanar. This allows the printed circuit board to be attached to the solid electrical conductor at multiple locations. Not only is the mechanical stability of the attachment increased this way, but also multiple locations with electrical connections are obtained, which can be utilized for electrical measurement applications, as will be described in further detail below.

Optionally, at least two pairs of tenons and elevations may be formed on the solid electrical conductor. Accordingly, at least two pairs of through-holes and conductive traces may be provided on the printed circuit board, thus establishing a certain redundancy for an electrical measurement application. In particular, the tenons and elevations of one pair may have the same distance to each other as the tenons and elevations of the other pair. Likewise, the through-holes and conductive traces of one pair may have the same distance to each other as the through-holes and conductive traces of the other pair. The tenons and elevations as well as the through-holes and conductive traces of each pair may be aligned along an axial direction of the solid electrical conductor.

To easily implement a direct temperature compensation, the electrical assembly may comprise a temperature sensor arranged on the above-mentioned back side of the printed circuit board facing the solid electrical conductor. The temperature sensor may be in thermal contact with the solid electrical conductor, directly and/or via a thermal paste. The measuring of the temperature sensor may be read by the electrical measurement device, in particular a temperature monitoring unit for the purpose of temperature compensation and temperature monitoring.

Since, according to the present invention, no separate connection element is arranged between the printed circuit board and the solid electrical conductor, the printed circuit board and the solid electrical conductor are relatively close to each other. This allows the use of surface mount devices (SMD) for the temperature monitoring unit. In particular, one or more thermistors, e.g. negative temperature coefficient (NTC) thermistors, may be surface-mounted to the back side of the printed circuit board facing the solid electrical conductor to form the temperature monitoring unit.

According to another possible embodiment of the electrical assembly, the solid electrical conductor may be a shunt resistor with at least one resistive element and at least one connection terminal arranged adjacent to the at least one resistive element. Preferably, the shunt resistor comprises two connection terminals with the resistive element located in between. The at least one tenon and the at least one elevation may be monolithically formed from the material of the resistive element or the connection terminals. As such, the electrical assembly of this embodiment can be utilized in an active shunt for the measurement of electrical currents, especially when the expected current values are too large to be directly measured by an ammeter. This will be described below: The shunt resistor can be arranged in a circuit in parallel with a voltmeter. For this, the at least one connection terminal may be configured as a terminal plate. Further, the at least one connection terminal may comprise at least one screw hole for connecting the shunt resistor to the circuit of which the current values are to be measured.

To achieve the parallel arrangement, the shunt resistor comprises a pair of tenons and elevations, wherein the voltmeter is connected through the printed circuit board with all tenons and elevations. Preferably, one tenon and one elevation are each positioned on opposite sides of the resistive element, such that the resistive element is parallel with the voltmeter.

The shunt resistor usually has a relatively low resistance, so that virtually all of the current to be measured will flow through the shunt resistor. The above-mentioned embossing of the at least one tenon moves the material from the core of the solid conductor into the volume of the tenon. The resulting indent can reach a depth of up to 80% of the material thickness of the solid conductor and form the above-mentioned indent. Consequently, the effect of a so-called current shadow is possible. In particular, the at least one indent creates a choke point that forces the electric current to flow as close as possible to the tenon and elevation on the opposite side of the shunt resistor.

The voltage across the shunt resistor is proportional to the current flowing through it and thus, the measured voltage can be scaled to directly display the current value. Therefore, the concrete resistance of the shunt resistor is chosen so that the resultant voltage drop is high enough to be measurable with the voltmeter, but low enough not to disrupt the circuit.

For the sake of accurate scaling, the actual resistance value of the shunt resistor has to be known as precisely as possible, since it influences the proportionality factor between the measured voltage and the current value. For this purpose, the resistive value of the resistive element needs to have a minimal temperature coefficient. That is, the resistance value of the resistive element should be virtually independent of the (operating) temperature. This is important, since electrical circuits tend to heat up under load.

For this reason, the resistive element may be comprised of or consist of resistance alloys, which are conventionally known under names such as Manganin, Constantan, Isaohm or any other conductive material with a low thermal variation of its resistivity.

Nonetheless, the shunt resistor as a whole (including all of its remaining components, such as the connection terminals) exhibits a certain temperature dependency on its overall resistance value. Therefore, temperature will inevitably have an undesired impact on the measurement results of the current value. To overcome this issue, different temperature compensation methods can be applied.

The initial objective is also achieved by an electrical measurement device comprising an electrical assembly according to any one of the described embodiments and an electrical sensor, wherein the electrical sensor is connected with the at least one conductive trace of the printed circuit board.

The electrical measurement device benefits from the above-explained advantages and functions of the electrical assembly. In particular, the manufacturability, profitability, reliability, and performance of the electrical measurement device is improved by using the electrical assembly according to the described embodiments.

Optionally, the at least one conductive trace of the printed circuit board may be connected with e.g., a sensor probe, a sensor wire and/or an internal printed circuit board of the electrical sensor.

An exemplary electrical sensor may be a voltmeter or any other type of voltage measurement device. As such, the electrical measurement device may, for example, be readily used as an active shunt according to the principles explained above.

According to a possible embodiment of the electrical measurement device, the electrical measurement device may comprise at least one screw and a housing in which the electrical assembly and electrical sensor are accommodated. As already described above, the shunt resistor may comprise at least one screw hole for passing the at least one screw.

The initial objective is also achieved by a method for manufacturing an electrical assembly comprising the steps of providing a substantially flat solid electrical conductor and a printed circuit board with at least one through-hole and at least one electrically conductive trace extending at least sectionally around the at least one through-hole, coining the solid electrical conductor to monolithically form, from the material of the solid electrical conductor, at least one tenon and at least one elevation extending around the at least one tenon, inserting the at least one tenon into the at least one through-hole with the at least one electrically conductive trace facing the solid electrical conductor, and bringing the at least one elevation in electrical contact with the at least one electrically conductive trace.

Compared to other manufacturing methods of comparable electrical assemblies, this inventive method produces less scrap and involves less parts, since the at least one tenon and the at least one elevation are formed by coining in a chipless manner. Further, the resulting electrical assembly exhibits the advantages and functions explained above.

Optionally, the method step of inserting may involve pressing in or press-fitting the at least one tenon into the at least one through-hole. Additional or alternative method steps may be soldering, welding, gluing and/or riveting the at least one tenon to the printed circuit board at the at least one through-hole.

Further, the method step of coining may involve stamping, pressing, punching and/or embossing the solid electrical conductor. Moreover, a staged tool and/or a progressive tool may be used for the method step of coining in order to achieve a high shape accuracy and high repeatability when forming the at least one tenon and the at least one elevation or multiple tenons and elevations in parallel.

In the following, exemplary embodiments of the invention are described with reference to the drawings. The embodiments described and shown in the drawings, are for explanatory purposes only. The combination of features shown in the embodiments may be changed according to the foregoing description. For example, a feature which is not shown in an embodiment, but described above, may be added if the technical effect associated with this feature is beneficial for a particular application. Vice versa, a feature shown as part of an embodiment may be omitted as described above, if the technical effect associated with this feature is not needed in a particular application.

In the drawings, elements that correspond to each other with respect to function and/or structure have been provided with the same reference numeral.

In the drawings,
- Fig. 1: shows a schematic representation of an exploded view of an electrical measurement device according to a possible embodiment of the present disclosure;
- Fig. 2: shows a schematic representation of a sectional view of an electrical assembly according to a first possible embodiment of the present disclosure;
- Fig. 3: shows a schematic representation of a sectional view of an electrical assembly according to a second possible embodiment of the present disclosure;
- Fig. 4: shows a schematic representation of a sectional view of an electrical assembly according to a third possible embodiment of the present disclosure;
- Fig. 5: shows a schematic representation of an exploded view of an electrical assembly according to a fourth possible embodiment of the present disclosure;
- Fig. 6: shows a schematic representation of a sectional view of the electrical assembly in Fig. 5;
- Fig. 7: shows a schematic representation of a top view of the electrical assembly in Fig. 5;
- Fig. 8: shows a schematic representation of a perspective view of a solid electrical conductor according to a possible embodiment of the present disclosure;
- Fig. 9: shows a schematic representation of a detail IX of Fig. 8;
- Fig. 10: shows a schematic representation of a perspective view of a tenon and elevation according to a possible embodiment of the present disclosure;
- Fig. 11: shows a schematic representation of a perspective view of a tenon and elevation according to another possible embodiment of the present disclosure; and
- Fig. 12: shows a schematic representation of a perspective view of a tenon and elevations according to another possible embodiment of the present disclosure.

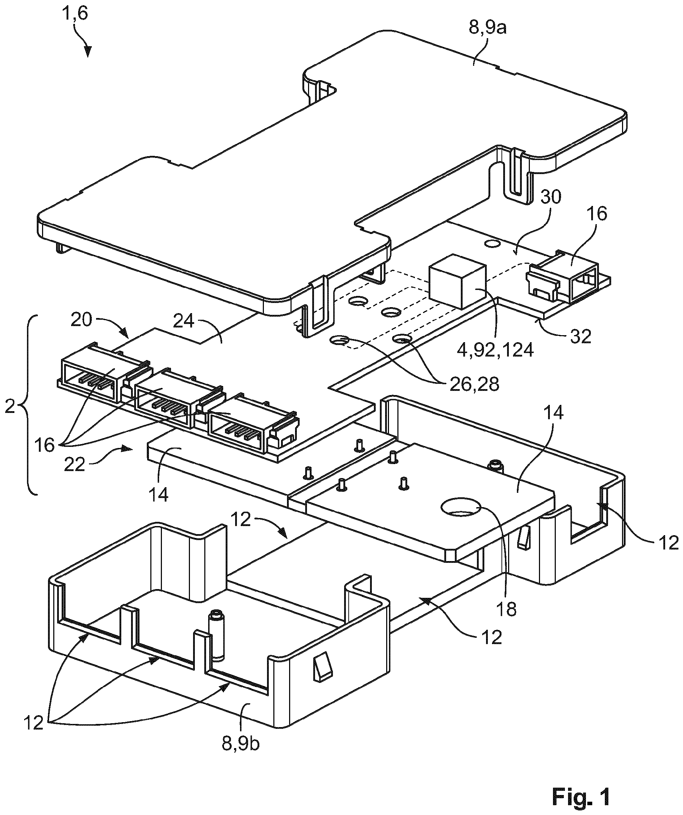

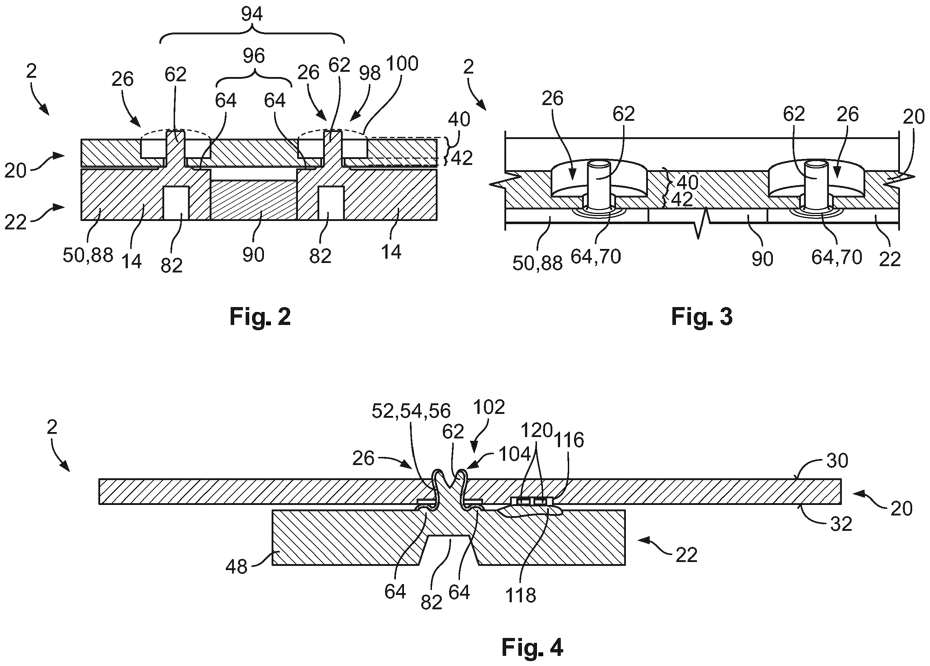

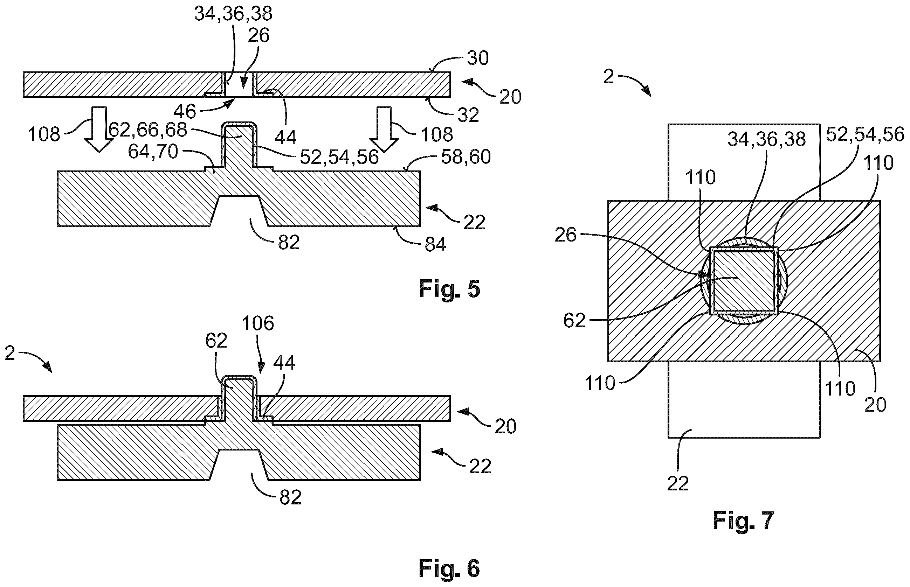

First, the structure of a possible embodiment of an electrical measurement device 1 according to the present invention is explained with reference to Fig. 1. Next, Figs. 2 to 11 are used to explain the structure of possible embodiments of an electrical assembly 2. Lastly, a manufacturing method according to the present invention is explained with reference to Figs. 5 to 7.

Fig. 1 shows an exploded view perspective of the electrical measurement device 1 according to one possible embodiment of the present disclosure. The electrical measurement device 1 comprises the electrical assembly 2 and an electrical sensor 4, which is connected to the electrical assembly 2. In this specific embodiment, the electrical measurement device 1 may be used, for example, as an active shunt 6 for the measurement of electrical currents. Especially when the expected current values are too large to be directly measured by an ammeter, the active shunt 6 is utilized. This will be explained further below.

Moreover, the electrical measurement device 1 may comprise a housing 8 in which the electrical assembly 2 and the electrical sensor 4 are accommodated. In the shown embodiment of Fig. 1, a two-part housing 8 comprised of two housing halves 9a, 9b is provided. The housing halves 9a, 9b may be configured to be clipped together. Alternatively, the housing halves 9a, 9b may also be glued, welded, soldered or screwed together.

Further, the housing 8 may have one or more access openings 12. Through these access openings 12, the electrical assembly 2 may be accessible from outside the housing 8. For example, the connection terminals 14 and/or card-edge connectors 16 of the electrical assembly 2 may extend through the access openings 12 or at least be aligned with the access openings 12 inside the housing 8. The connection terminals 14 may be plate-shaped and each comprise a screw hole 18 for passing a screw (not shown). The corresponding screw may be an optional part of the electrical measurement device 1.

In Fig. 2, a sectional view of a possible embodiment of the electrical assembly 2 is shown. As can be seen, the electrical assembly 2 comprises a printed circuit board 20 attached to a solid electrical conductor 22.

The printed circuit board 20 may comprise a substrate 224 made of glass-reinforced epoxy laminate material, in particular of the category FR-4 according to NEMA LI 1-1998 standard. Through the substrate of the printed circuit board 20, at least one through-hole 26, in particular a via 28 (vertical interconnect access) may extend. As such, the at least one through-hole 26 may connect a top side 30 of the printed circuit board 20 with a bottom side 32 of the printed circuit board 20.

The at least one through-hole 26 may comprise an electrically conductive internal surface 34. In particular, the electrically conductive internal surface 34 may be achieved through a metallic plating 36, metallic coating 38 and/or metallic insert sleeve (not shown) within the at least one through-hole 26.

As can be seen in Fig. 2, the at least one through-hole 26 may comprise a stepped portion separating a wider section 40 from a narrower section 42. For example, the wider section 40 is obtained as a counterbore hole or countersink hole on the top side 30.

On the bottom side 32, the printed circuit board 20 comprises at least one electrically conductive trace 44 (see Fig. 5) extending at least sectionally around the at least one through-hole 26, in particular around an opening 46 of the at least one through-hole 26. Herein, the at least one electrically conductive trace 44 may border or at least be closer to the narrower section 42 than to the wider section 40. The at least one electrically conductive trace 44 may extend continuously or discontinuously around the at least one through-hole 26. Preferably, the electrically conductive internal surface 34 and the at least one conductive trace 44 are electrically interconnected.

The solid electrical conductor 22 may be a busbar 48, a shunt 50 or any other type of conductor massively made of electrically conductive material. For example, the solid electrical conductor 22 may be made of copper, copper alloy, in particular copper wrought alloy, aluminum, aluminum alloy, stainless steel or any other metallic or metallized material with a ductility suitable for coining, stamping, pressing, punching, embossing and/or similar processes. Optionally, the solid electrical conductor 22 may at least in sections comprise a coating 52, plating 54 or brazing 56 of a rare metal (e.g., silver) or a rare metal alloy.

Further, the solid electrical conductor 22 may be substantially flat or have at least one flat side 58. Said flat side 58 may be facing towards the bottom side 32 of the printed circuit board 20 and may be referred to as a top side 60 of the solid electrical conductor 22. On said top side 60, at least one tenon 62 and at least one elevation 64 extending around the at least one tenon 62 may be monolithically formed from the material of the solid electrical conductor 22. In particular, the at least one tenon 62 and the at least one elevation 64 may be formed by coining, stamping, pressing, punching or embossing the solid electrical conductor 22. Hence, the above-mentioned requirement of material ductility for the solid electrical conductor 22 is set.

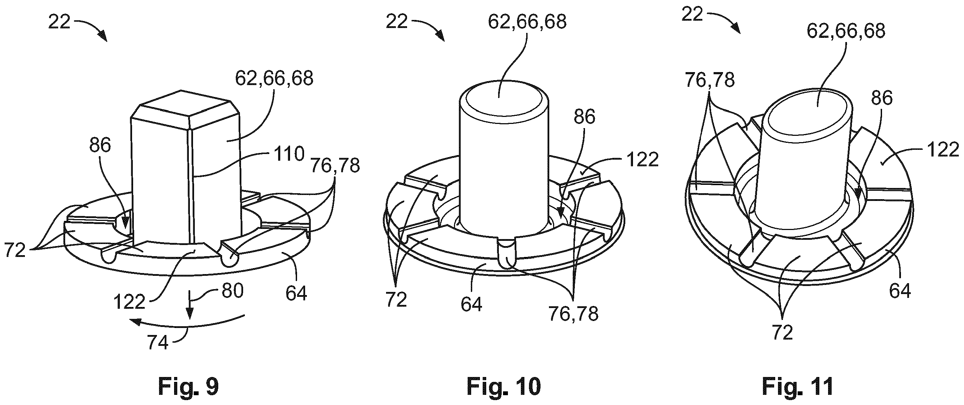

The at least one tenon 62 may be a pillar-shaped, pin-shaped, prism-shaped, pole-shaped and/or post-shaped finger 66 or protrusion 68. As such, the at least one tenon 62 may protrude from the top side 60 of the solid electrical conductor 22. Further, the at least one tenon 62 may have a circular or non-circular cross section. For example, the at least one tenon 62 may have a square (see Fig. 9), circular (see Fig. 10), or elliptical (see Fig. 11) cross-section. In particular, an outer contour of the at least one tenon 62 may be cuboidal (see Fig. 9), cylindrical (see Fig. 10) or cylindroidal (see Fig. 11).

The at least one elevation 64 may extend continuously around the at least one tenon 62. For example, the at least one elevation 64 may be a ring-shaped bulge 70 on the top side 60 of the solid electrical conductor 22 encircling the at least one tenon 62.

Alternatively, the at least one elevation 64 may extend discontinuously around the at least one tenon 62. For example, the at least one elevation 64 may be distributed around the at least one tenon 62 in the form of multiple ring segments 72. The ring segments 72 are preferably distributed in a circular arrangement and evenly spaced apart from each other in a circumferential direction 74 with respect to the at least one tenon 62. Moreover, the ring segments 72 may be mutually coplanar. Between individual ring segments 72, slits 76 or notches 78 extend through the at least one elevation 64 along a radial direction 80 with respect to the at least one tenon 62.

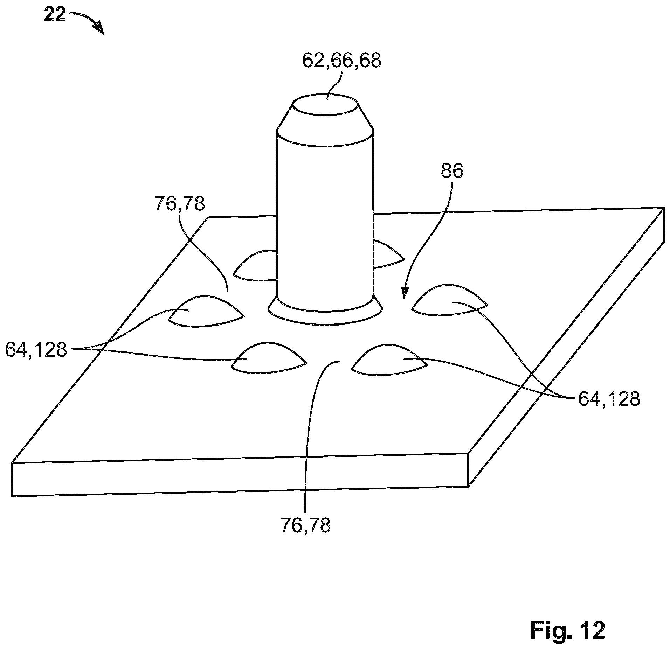

Instead of the ring segments 72, protrusions, in particular convex knobs 128 (see Fig. 12) with a dome shape, spike shape, pyramid shape, cylinder shape, star shape or any other convexly protruding shape may be distributed around the at least one tenon 62.

The at least one elevation 64 may form a substantially flat contact surface 122 for the at least one conductive trace 44. As can be seen in Fig. 4, the solid electrical conductor 22 may comprise at least one indent 82 on a bottom side 84 of the solid electrical conductor 22 facing away from the printed circuit board 20. More specifically, the at least one indent 82 is located opposite of the at least one tenon 62 and the at least one elevation 64 with respect to the solid electrical conductor 22. This is a result of material displacement during the monolithic formation of the at least one tenon 62 and the at least one elevation 64 from the material of the solid electrical conductor 22. Optionally, a groove 86 is formed on the solid electrical conductor 22 between the at least one tenon 62 and the at least one elevation 64 (see Fig. 9). Said groove 86 may be circular and/or annular and may extend around the at least one tenon 62 in the circumferential direction 74 with respect to the at least one tenon 62. In the radial direction 80 with respect to the at least one tenon 62, the groove 86 may separate the at least one tenon 62 and the at least one elevation 64 from each other.

In the shown embodiment of Fig. 1, the solid electrical conductor 22 may be a shunt resistor 88 with at least one resistive element 90 and at least one connection terminal 14 arranged adjacent to the at least one resistive element 90. Preferably, the shunt resistor 88 comprises two connection terminals 14 with the resistive element 90 located in between. The at least one tenon 62 and the at least one elevation 64 may be monolithically formed from the material of the resistive element 90 or the connection terminals 14.

The connection terminals 14 may be made of the same materials as already mentioned for the solid electrical conductor 22. The resistive element 90 may be comprised of or consist of resistance alloys, which are conventionally known under names such as Manganin, Constantan, Isaohm or any other conductive material with a low thermal variation of its resistivity.

The shunt resistor 88 can be arranged in a circuit (not shown) in parallel with a voltmeter 92 in order to be used in the active shunt 6 already mentioned above. To achieve the parallel arrangement, the shunt resistor 88 may comprise a pair 94 of tenons 62 and a pair 96 of elevations 64. Preferably, one tenon 62 of the pair 94 and one elevation 64 of the pair 96 are positioned on each of two opposite sides of the resistive element 90. The voltmeter 92 is connected through the printed circuit board 20 with the tenons 62 and elevations 64 such that the resistive element 90 is parallel with the voltmeter 92.

In particular, each tenon 62 extends into one through-hole 26 of the printed circuit board 20, which comprises the necessary number of through-holes 26. Here, the through-holes 26 primarily function as mortises and create joints with the corresponding tenons 62. If present, the electrically conductive internal surfaces 34 of the through-holes 26 may enter into electrical contact with the corresponding tenons 62. Further, each elevation 64 is in electrical contact with one electrically conductive trace 44 of the printed circuit board 20, which comprises the necessary number of traces 44.

Each tenon 62 may be engaged in a soldered connection 98 with the printed circuit board 20 at the respective through-hole 26. This is exemplarily shown in Fig. 2. Here, the wider section 40 is filled with solder 100 for fixation purposes and the narrower section 42 is solder-filled for contacting purposes.

In the context of this soldered connection 98, the function fulfilled by the above-mentioned slits 76 can be explained. The slits 76 help with the de-aerating or venting of each through-hole 26 during soldering. That is, a solid electrical conductor 22 with a continuously extending elevation 64 (see Fig. 3) would shut the through-holes 26 and virtually turn them into blind holes, once the electrically conductive traces 44 were brought into electrical contact with the elevations 64. Without any means of escape, an air/gas pocket would accumulate in the through-holes 26, preventing solder from sufficiently filling the narrower section 42. The slits 76 provide the necessary vent for any trapped air/gas.

Alternatively, the at least one tenon 62 may be engaged in a riveted connection 102 with the printed circuit board 20 at the at least one through-hole 26 (see Fig. 4). For this, a tip 104 of the at least one tenon 62 may be flush with the top side 30 of the printed circuit board 20 or may even project from the top side 30 of the printed circuit board 20, when the at least one tenon 62 extends into the at least one through-hole 26 of the printed circuit board 20. Subsequently, the tip 104 is center-punched, which leads to a widening of the tip 104 and results in the riveted connection 102.

According to another alternative embodiment shown in Figs. 5 to 7, the at least one tenon 62 may be engaged in a press-fit connection 106 with the printed circuit board 20 at the at least one through-hole 26. Optionally, the press-fit connection 106 is obtained by a so-called massive press fit. For this purpose, the at least one tenon 62 may have a slightly over-sized non-circular cross section and the at least one through-hole 26 may have a slightly under-sized circular cross section. This deliberate mismatch between the shapes and sizes of the cross sections can be best seen in Fig. 7. It is also conceivable that the at least one through-hole 26 has a non-circular cross section (not shown), while the at least one tenon 62 is cylindrically shaped.

With this mismatch in place, the at least one tenon 62 is forced into the at least one through-hole 26, as is depicted with arrows 108 in Fig. 5. Preferably, the at least one tenon 62 comprises at least one edge 110 that incises into the electrically conductive internal surface 34 of the at least one through-hole 26. In the course of this massive press fit, the electrically conductive internal surface 34 of the at least one through-hole 26 is, at least in sections, cold welded with the at least one tenon 62.

According to another possible embodiment not shown in the figures, the at least one tenon may be arranged eccentrically with respect to the at least one through-hole and may one-sidedly engage with the internal surface of the at least one through-hole in a frictional manner. In particular, a distance *D* by which a middle axis of the at least one tenon is shifted from a middle axis of the at least one through-hole may be equal to or larger than the difference between the inner radius *R* of the at least one through-hole and the outer radius *r* of the at least one tenon (*D* ≥ *R* - *r*).

In this case, the circularity of the cross section of the at least one tenon and the at least one through-hole is irrelevant. However, it has to be ensured that the printed circuit board cannot "shift back" relative to the solid electrical conductor. For example, multiple pairs of tenons and through-holes are provided, wherein the middle axes of the tenons are shifted in mutually opposite directions from the middle axes of the through-holes. Alternatively, if only one tenon and one through-hole is present, the aforementioned housing 8 may guarantee that the printed circuit board and the solid electrical conductor are fixated in their relative positions, so that the at least one tenon is arranged eccentrically with respect to the at least one through-hole.

As suggested above, two or more tenons 62 may be formed on the solid electrical conductor 22, wherein each tenon 62 is surrounded by an elevation 64 formed on the solid electrical conductor 22. Accordingly, the printed circuit board 20 may comprise two or more through-holes 26 surrounded by electrically conductive traces 44 at locations corresponding with the respective locations of the tenons 62 and elevations 64.

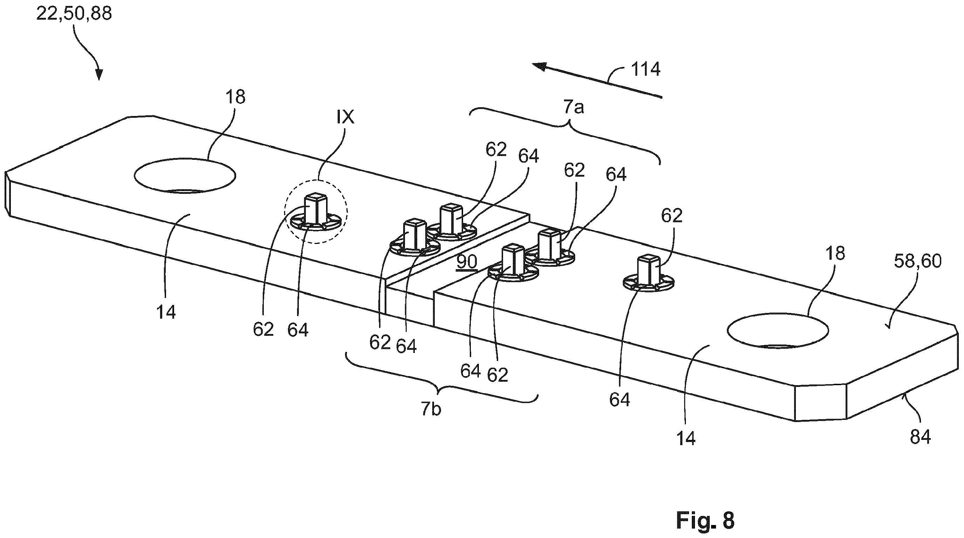

From Fig. 8 it can be seen that the two or more tenons 62 may be mutually parallel. The two or more through-holes 26 likewise may extend parallel to each other. The elevations 64 may be mutually coplanar, just like the electrically conductive traces 44 are mutually coplanar.

Optionally, at least two pairs 7a, 7b of tenons 62 and elevations 64 may be formed on the solid electrical conductor 22. Accordingly, at least two pairs of through-holes and conductive traces may be provided on the printed circuit board. In particular, the tenons 62 and elevations 64 of one pair 7a may have the same distance to each other as the tenons 62 and elevations 64 of the other pair 7b. Likewise, the through-holes and conductive traces of one pair may have the same distance to each other as the through-holes and conductive traces of the other pair. The tenons and elevations as well as the through-holes and conductive traces of each pair may be aligned along an axial direction 114 of the solid electrical conductor 22.

To directly implement a means for temperature compensation, the electrical assembly 2 may comprise a temperature sensor 116 arranged on the above-mentioned bottom side 32 of the printed circuit board 20 facing the solid electrical conductor 22. The temperature sensor 116 may be in thermal contact with the solid electrical conductor 22, directly and/or via a thermal paste 118 (see Fig. 4). The measured temperatures of the temperature sensor 116 may be read by the electrical measurement device 1, in particular a temperature monitoring unit for the purpose of the temperature compensation.

Since, according to the present invention, no separate connection element is arranged between the printed circuit board 20 and the solid electrical conductor 22, the printed circuit board 20 and the solid electrical conductor 22 are relatively close to each other. This allows for the use of surface mount devices (SMD) for the temperature sensor 116. In particular, one or more thermistors, e.g. negative temperature coefficient (NTC) thermistors 120 or positive temperature coefficient (PTC) thermistors may be surface-mounted to the bottom side 32 of the printed circuit board 20 facing the solid electrical conductor 22.

The electrical sensor 4 of the electrical measurement device 1 is connected with the at least one conductive trace 44 of the printed circuit board 20. This is shown in Fig. 1. For example, the at least one conductive trace 44 of the printed circuit board 20 may be connected with e.g., a sensor probe (not shown), a sensor wire (not shown) and/or an internal printed circuit board (not shown) of the electrical sensor 4. An exemplary electrical sensor 4 may be or comprise the voltmeter 92 already mentioned above or any type of signal conditioning device 124.

Lastly, a method for the manufacturing of the electrical assembly 2 is explained: First, a substantially flat, solid electrical conductor (not shown in this state) and a printed circuit board 20 with at least one through-hole 26 and at least one electrically conductive trace 44 extending at least sectionally around the at least one through-hole 26 are provided.

The solid electrical conductor 22 is coined to monolithically form, from the material of the solid electrical conductor, at least one tenon 62 and at least one elevation 64 extending around the at least one tenon 62 (see Fig. 5). This coining procedure may involve stamping, pressing, punching and/or embossing the solid electrical conductor 22. Moreover, a staged tool (not shown) and/or a progressive tool (not shown) may be used for this coining procedure.

Thereafter, the at least one tenon 62 is inserted into the at least one through-hole 26 with the at least one electrically conductive trace 44 e.g., an annular ring facing the solid electrical conductor 22. This insertion procedure may involve pressing in or press-fitting the at least one tenon 62 into the at least one through-hole 26. Additionally or alternatively, soldering, welding, gluing and/or riveting the at least one tenon 62 to the printed circuit board 20 at the at least one through-hole 26 may be undertaken.

Thereby, the at least one elevation 64 is brought into electrical contact with the at least one electrically conductive trace 44 (see Fig. 6).

Any references to standards made in the present disclosure are to be understood as pointing to the latest version of the respective standard at the application date of the present disclosure.

### REFERENCE SIGNS

- 1: electrical measurement device
- 2: electrical assembly
- 4: electrical sensor
- 6: active shunt
- 7a, 7b: pair
- 8: housing
- 9a, 9b: housing half
- 12: access opening
- 14: connection terminals
- 16: card-edge connectors
- 18: screw hole
- 20: printed circuit board
- 22: solid electrical conductor
- 24: substrate
- 26: through-hole
- 28: via
- 30: top side
- 32: bottom side
- 34: internal surface
- 36: metallic plating
- 38: metallic coating
- 40: wider section
- 42: narrower section
- 44: conductive trace
- 46: opening
- 48: busbar
- 50: shunt
- 52: coating
- 54: plating
- 56: brazing
- 58: flat side
- 60: top side
- 62: tenon
- 64: elevation
- 66: finger
- 68: protrusion
- 70: ring-shaped bulge
- 72: ring segment
- 74: circumferential direction
- 76: slit
- 78: notch
- 80: radial direction
- 82: indent
- 84: back side
- 86: groove
- 88: shunt resistor
- 90: resistive element
- 92: voltmeter
- 94: pair
- 96: pair
- 98: soldered connection
- 100: solder
- 102: riveted connection
- 104: tip
- 106: press-fit connection
- 108: arrow
- 110: edge
- 114: axial direction
- 116: temperature sensor
- 118: thermal paste
- 120: thermistor
- 122: contact surface
- 124: signal conditioning device
- 128: knob

## Claims

1. Electrical assembly (2) for an electrical measurement device (1), the electrical assembly (2) comprising
- a solid electrical conductor (22) and
- a printed circuit board (20) with at least one through-hole (26) and at least one electrically conductive trace (44) extending at least sectionally around the at least one through-hole (26),
wherein on the solid electrical conductor (22) at least one tenon (62) and at least one elevation (64) extending around the at least one tenon (62) are monolithically formed from the material of the solid electrical conductor (22),
wherein the at least one tenon (62) extends into the at least one through-hole (26), and wherein the at least one elevation (64) is in electrical contact with the at least one electrically conductive trace (44).

2. Electrical assembly (2) according to claim 1, wherein the at least one tenon (62) is engaged in one of a soldered, welded, glued, riveted and press-fit connection (98, 102, 106) with the printed circuit board (20) at the at least one through-hole (26).

3. Electrical assembly (2) according to claim 1 or 2, wherein the at least one elevation (64) extends one of continuously and discontinuously around the at least one tenon (62).

4. Electrical assembly according to any one of claims 1 to 3, wherein the at least one elevation (64) is formed by multiple protrusions distributed around the at least one tenon (62), each protrusion defining a discrete contact point for the at least one electrically conductive trace (44).

5. Electrical assembly (2) according to any one of claims 1 to 4, wherein the at least one through-hole (26) comprises an electrically conductive internal surface (34) that is in electrical contact with the at least one tenon (62).

6. Electrical assembly (2) according to any one of claims 1 to 5, wherein a groove (86) is formed on the solid electrical conductor (22) between the at least one tenon (62) and the at least one elevation (64).

7. Electrical assembly (2) according to any one of claims 1 to 6, wherein the at least one through-hole (26) comprises a stepped portion separating a wider section (40) of the at least one through-hole (26) from a narrower section (42) of the at least one through-hole (26), and wherein the at least one electrically conductive trace (44) borders the narrower section (42).

8. Electrical assembly (2) according to any one of claims 1 to 7, wherein at least one slit (76) extends through the at least one elevation (64) along a radial direction (80) with respect to the at least one tenon (62).

9. Electrical assembly (2) according to any one of claims 1 to 8, wherein, on a bottom side (84) of the solid electrical conductor (22) facing away from the printed circuit board (20), the solid electrical conductor (22) comprises at least one indent (82), wherein the at least one indent (82) is located opposite of the at least one tenon (62) and of the at least one elevation (64) with respect to the solid electrical conductor (22).

10. Electrical assembly (2) according to any one of claims 1 to 9, wherein the at least one tenon (62) has one of a circular and non-circular cross section.

11. Electrical assembly (2) according to any one of claims 1 to 10, wherein the electrical assembly (2) comprises a temperature sensor (116) arranged on a bottom side (32) of the printed circuit board (20) facing the solid electrical conductor (22).

12. Electrical assembly (2) according to any one of claims 1 to 11, wherein the solid electrical conductor (22) is a shunt resistor (88) with at least one resistive element (90) and at least one connection terminal (14) arranged adjacent to the at least one resistive element (90).

13. Electrical measurement device (1) comprising an electrical assembly (2) according to any one of claims 1 to 12 and an electrical sensor (4), wherein the electrical sensor (4) is connected with the at least one conductive trace (44) of the printed circuit board (20).

14. Method for the manufacturing of an electrical assembly (2) comprising the steps of:
- providing a substantially flat, solid electrical conductor and a printed circuit board (20) with at least one through-hole (26) and at least one electrically conductive trace (44) extending at least sectionally around the at least one through-hole (26),
- coining the solid electrical conductor to monolithically form, from the material of the solid electrical conductor, at least one tenon (62) and at least one elevation (64) extending around the at least one tenon (62),
- inserting the at least one tenon (62) into the at least one through-hole (26) with the at least one electrically conductive trace (44) facing the solid electrical conductor (22), and
- bringing the at least one elevation (64) into electrical contact with the at least one electrically conductive trace (44).

15. Method according to claim 14, wherein at least one of a staged tool and a progressive tool is used for the method step of coining.
